Europäisches Patentamt

European Patent Office

Office européen des brevets

(19)

(11) Veröffentlichungsnummer: **0 239 652 B1**

(12) **EUROPÄISCHE PATENTSCHRIFT**

(45) Veröffentlichungstag der Patentschrift: **24.07.91**

(51) Int. Cl.⁵: **H01L 21/82**, H01L 27/06

(21) Anmeldenummer: **86103946.9**

(22) Anmeldetag: **22.03.86**

(54) **Verfahren zum Herstellen einer monolithisch integrierten Schaltung mit mindestens einem bipolaren Planartransistor.**

(43) Veröffentlichungstag der Anmeldung:
**07.10.87 Patentblatt 87/41**

(45) Bekanntmachung des Hinweises auf die
Patenterteilung:
**24.07.91 Patentblatt 91/30**

(84) Benannte Vertragsstaaten:
**DE FR GB IT NL**

(56) Entgegenhaltungen:
**EP-A- 0 071 665**
**EP-A- 0 101 000**
**EP-A- 0 139 266**
**FR-A- 2 531 812**

(73) Patentinhaber: **Deutsche ITT Industries GmbH**
**Hans-Bunte-Strasse 19 Postfach 840**
**W-7800 Freiburg i.Br.(DE)DE**

Patentinhaber: **ITT INDUSTRIES INC.**
**320 Park Avenue**
**New York, NY 10022(US)FR GB IT NL**

(72) Erfinder: **Blossfeld, Lothar, Dipl.-Phys.**
**Waldstrasse 23**
**W-7801 Freiburg-Hochdorf(DE)**

(74) Vertreter: **Klunker . Schmitt-Nilson . Hirsch**
**Winzererstrasse 106**
**W-8000 München 40(DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Die Erfindung beschäftigt sich mit einem Verfahren, welches zum Herstellen von monolithisch integrierten Höchstfrequenzschaltungen geeignet ist, welche zumindest je einen integrierten bipolaren Planartransistor enthalten, also auch noch weitere integrierte Bauelemente, wie Isolierschicht-Feldeffekttransistoren, integrierte Kapazitäten oder auch integrierte Widerstände. Das Verfahren nach der Erfindung wie auch die Erörterung des Standes der Teohnik wird jedoch zur Erleichterung des Verständnisses und zur Vereinfachung der Beschreibung auf ein Verfahren zur Herstellung einer monolithisch integrierten Schaltung mit mindestens einem bipolaren Planartransistor bezogen. Darin ist also keine Einschränkung zu sehen, zumal es seit langem üblich ist, monolithisch integrierte Schaltungen an einer in die einzelnen Schaltungen zu zerteilenden größeren Halbleiterplatte gemeinsam herzustellen und erst abschließend einzeln zu verkapseln.

Ein Verfahren solcher Art ist in den Offenlegungsschriften DE-A 32 43 059 oder DE-A 31 29 539 beschrieben. Dabei werden dotierte polykristalline Silicium-Schichten verwendet, um in selbstjustierender Weise die Basiskontaktierungszone mit ihrer Basiselektrode und die Emitterzone mit ihrer Emitterelektrode in unmittelbarer Nähe zueinander herzustellen. Damit wird ein sehr geringer Basiszuleitungswiderstand und eine relativ hohe Arbeitsgeschwindigkeit erzielt. Außerdem hat ein solches selbstjustierendes Verfahren grundsätzlich den Vorteil, daß Sicherheitsabstände bei den photolithographischen Prozessen auf ein Minimum gebracht werden können, so daß die seitlichen Abmessungen der bipolaren Planartransistoren verringert werden können. Der Nachteil des Verfahrens der oben genannten DE-A 31 29 539 besteht darin, daß ein aufwendiger Epitaxieprozeß angewendet wird, der die Ausbeute erfahrungsgemäß kleinhält. Ein Nachteil des Verfahrens nach der genannten DE-A 32 43 059 besteht darin, daß die Überlappungskapazität zwischen der Emitterelektrode und der Basiseleketrode die Arbeitsgeschwindigkeit begrenzt.

Die Erfindung geht daher von dem Verfahren der EP-A-71 665 aus, das die vorstehend genannte Nachteile im wesentlichen überwindet, wobei der Gedanke der DE-OS 31 29 539 aufgegriffen wird, die Bahnwiderstände der polykristallinen Silicium-Elektroden, welche in verbindende Leiterbahnen übergehen, mit oberflächlichen Silicidschichten zu versehen, um die Zuleitungswiderstände zu erniedrigen. Dies hat ebenfalls eine Erhöhung der Arbeitsgeschwindigkeit der monolithisch integrierten Schaltung zur Folge.

Während sich die vorstehend genannten DE-Offenlegungsschriften nicht mit der Herstellung der Kollektorelektrode beschäftigen, wird bei einer Ausführungsform des Verfahrens nach der EP-A-71 665 zwar die Kollektorkontaktierungszone selbstausrichtend Emitterzone und zur Basiskontaktierungszone hergestellt, was aber nicht für die Herstellung der Kontakte an den zu kontaktierenden Zonen gilt.

Bei dem bekannten Verfahren der vorstehend genannten EP-A-71 665 zum Herstellen einer monolithisch integrierten Schaltung mit mindestens einem bipolaren Planartransistor bildet dessen an einer Hauptfläche eines Halbleitersubstrats liegende Kollektorzone an dieser Oberflächenseite innerhalb der Öffnung einer Feldoxidschicht einen Kollektorbereich . Zum Herstellung von Emitterzone und Basiszone selbstausrichtend zueinander wird der Emitterbereich mit einem Oxidationsmaskierungsschichtteil einer ersten Oxidationsmaskierungschicht solcher Dicke bedeckt, daß diese bei einem Ionenimplantationsprozeß hoher Energie von Dotierungen der Basiszone durchdrungen und bei einem anderen Ionenimplantationsprozeß niedriger Energie von Dotierungen der Basiszone maskiert wird. Nach den Implantationsprozessen, welche unter Verwendung eine den Basisbereich definierenden Implantationsmaske erfolgen, wird die freiliegende Halbleiteroberfläche unter Bildung eines den Emitterbereich umgebenden Oxidrahmens thermisch oxidiert und danach der erste Oxidationsmaskierungschichtteil entfernt. Schließlich wird die Hauptfläche mit einer Fremdoxidschicht bedeckt, welche Konaktöffnungen zu den Zonen aufweisen, die durch die Kontaktöffnungen hindurch mittels Elektroden kontaktiert werden. Die Kontaktierung der Zonen erfolgt, wie es bei planaren integrierten Schaltungen üblich ist, über Leiterbahnen, welche auf thermisch erzeugten Oxidschichten und/oder auf einer Fremoxidschicht verlaufen und welche durch Kontaktöffnungen in diesen isolierenden Schichten hindurch die Zonen oder auch bereits an den Zonen angebrachte Elektroden kontaktieren.

Zur Herstellung der Kontaktierungsöffnungen in den loslierschichten ist ein besonderer photolithographischer Ätzprozeß mit einem bestimmten seitlichen Sicherheitsabstand relativ zu den zu kontaktierenden Zonen erforderlich, um den Kurzschluß eines pn-Übergangs an der Halbleiteroberfläche auszuschließen. Daraus ergibt sich die der Erfindung zugrundeliegende Aufgabe der Angabe eines von dem Verfahren der oben genannten EP-A-71 665 ausgehenden Verfahrens, welches die selbstausrichtende Herstellung sämtlicher Zonen des Planartransistors zu den sie kontaktierenden Zonen erlaubt. Diese Aufgabe wird bei dem bekannten Verfahren gemäß dem Oberbegriff des Anspruchs 1 erfindungsgemäß durch die in seinem kennzeichnenden Teil angegebenen Prozesse gelöst.

Die Lösung der genannten Aufgabe liegt im Rahmen der Lösung der Rahmenaufgabe einer Erhöhung der Arbeitsgeschwindigkeit. Zur Lösung dieser Rahmenaufgabe liefert das Verfahren der Erfindung insofern einen Beitrag, als die niederohmige Kontaktierung der Basiszone in unmittelbarer Nähe der Emitterzone ohne Einhaltung eines Sicherheitsabstandes möglich ist.

Das Verfahren der Erfindung hat ferner den Vorteil, daß es hinsichtlich der Mitintegration von IsolierschichtFeldeffekttransistoren gemäß dem Anspruch 1 mit dem Verfahren der genannten EP-A1-71-665 kompatibel ist.

Mit den Verfahrensmaßnahmen der Ansprüche 3 und 4 läßt sich in vorteilhafter Weise das Verfahren nach der Erfindung insofern weiterbilden, als ebenfalls eine weitere Erhöhung der Arbeitsgeschwindigkeit in monolithisch integrierten Schaltungen erzielbar ist.

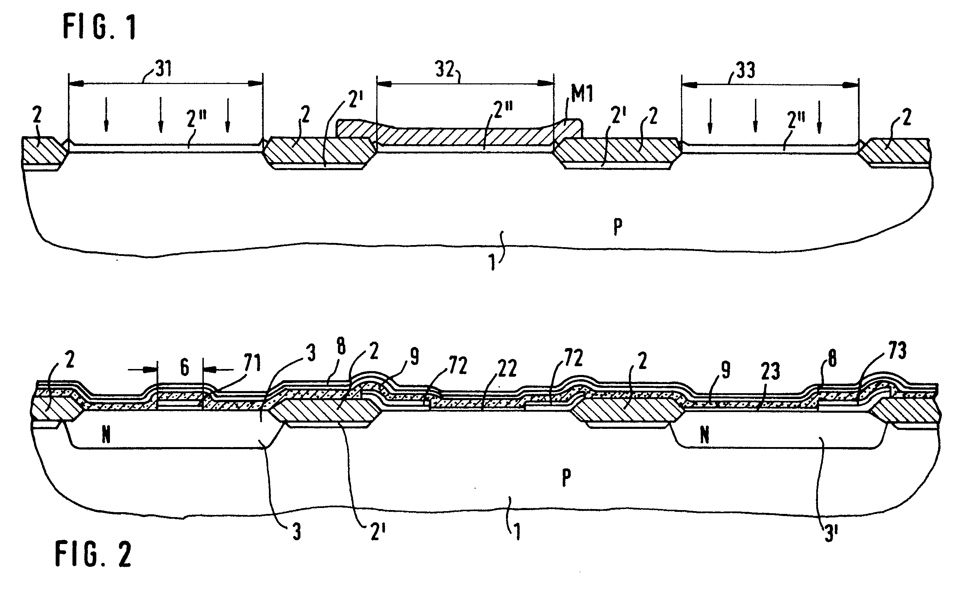

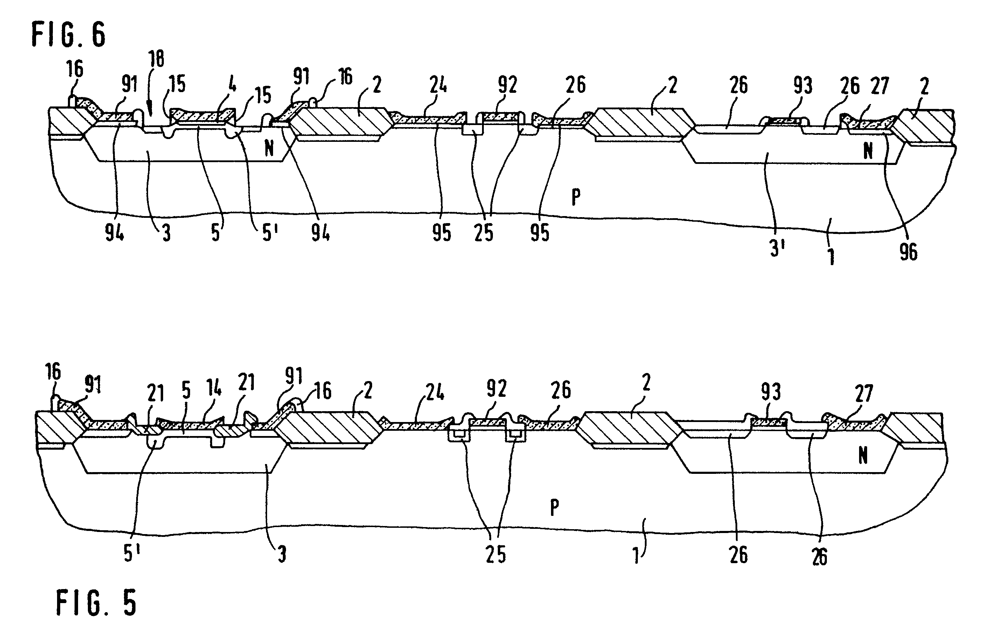

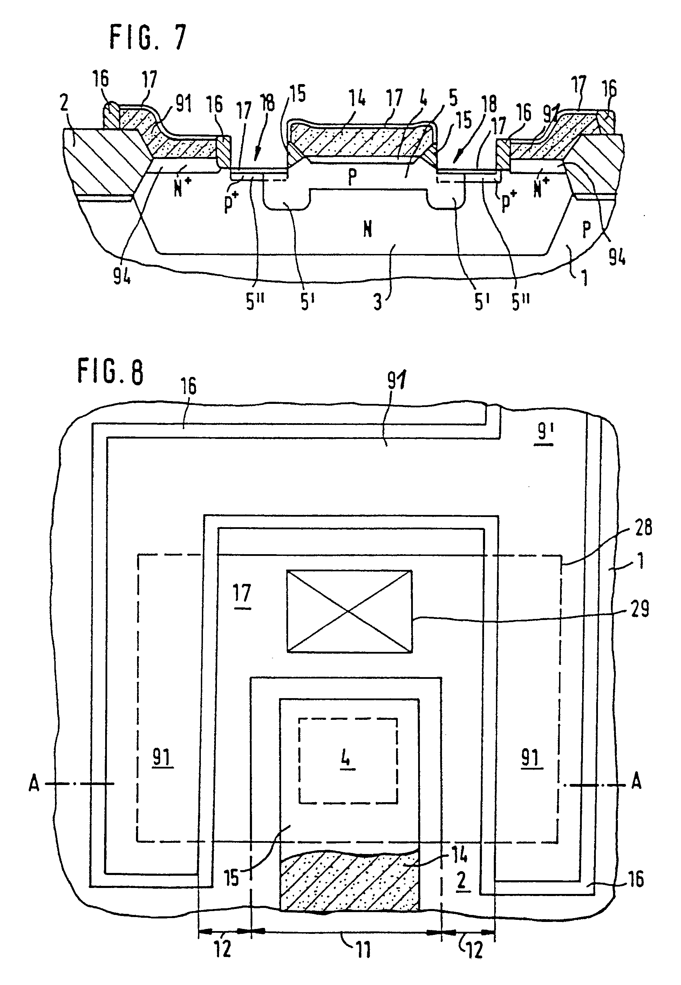

Das Verfahren nach der Erfindung und seine vorteilhaften Weiterbildungen werden im folgenden anhand der Zeichnung erläutert,
deren Fig. 1 bis 6 zur Erläuterung der aufeinanderfolgenden Prozesse des Verfahrens nach der Erfindung dienen,
deren Fig. 7 in Ausschnittsansicht den bipolaren Planartransistor in dem anhand der Fig. 6 veranschaulichten Stadium zeigt und
deren Fig. 8 die Aufsicht der Ausschnittsansicht der Fig. 7 veranschaulicht.

Die Figuren 1 bis 6 der Zeichnung beziehen sich auf ein Ausführunsbeispiel des Verfahrens nach der Erfindung, bei dem monolithisch integrierte Schaltungen hergestellt werden, die nicht nur bipolare Planartransistoren, sondern auch noch Isolierschicht-Feldeffekttransistoren enthalten, die gleichzeitig in derselben Halbleiterplatte hergestellt werden können. Ein Herstellungsverfahren, welches die Herstellung von bipolaren Planartransistoren an einer Halbleiterplatte gleichzeitig mit integrierten CMOS-Schaltungen erlaubt, ist bereits Gegenstand zahlreicher Veröffentlichungen und der Weiterbildung der Erfindung gemäß dem Anspruch 2.

Das anhand der Figuren 1 bis 6 der Zeichnung erläuterte Ausführungsbeispiel betrifft daher eine solche Weiterbildung, bei der gleichzeitig mit einem bipolaren Planartransistor ein komplementäres Paar von Si-Gate-Feldeffekttransistoren hergestellt wird. Die Figuren zeigen schematisch einen Ausschnitt einer solchen monolithisch integrierten Festkörperschaltung in üblicher Schrägschnittansicht, wobei der bipolare Planartransistor in der Öffnung 31 der Feldoxidschicht 2, ein N-Kanal-Feldeffekttransistoren innerhalb der Bereich 32 und ein P-Kanal-Feldeffekttransistior innerhalb der Öffnung 33 der Feldoxidschicht 2 hergestellt wird. Die Feldoxidschicht 2 kann in bekannter Weise unter Anwendung einer Oxidationsmaskierungsschicht hergestellt werden, wobei unter der Feldoxidschicht 2

kanalunterbrechende Schichten 2' vom gleichen Leitungstyp wie der Leitungstyp des Substrats 1 vorgesehen sind. Bei der Herstellung der Substratzonen 3 und 3' im p-leitenden Substrat 1 wird gemäß der Fig. 1 der Bereich 32 mittels der Implantationsmaske M1 bedeckt, so daß bei der anschließenden Implantation von n-dotierenden Verunreinigungen nur die Substratoberfläche innerhalb der Bereiche 31 und 33 dotiert wird. Bei einem anschließend nach der Entfernung der Implantationsmaske M1 erfolgenden Diffusionsprozeß werden die Substratzonen 3 und 3' gemäß der Fig. 2 erhalten. Nach Entfernung der Oxidationsmaskierungsschicht 2" wird der den Emitterbereich 6 bedeckende erste Oxidationsmaskierungsschichtteil 71 hergestellt. Zu diesem Zwecke wird die gesamte Hauptfläche der Anordnung mit einer Si-Nitridschicht oder mit einer aus einer Doppelschicht aus einem Siliciumnitrid und einem Siliciumoxid bestehenden Schichtenfolge bedeckt, aus der unter Anwendung eines photolithographischen Ätzprozesses mit bekannten Ätzmitteln der Oxidationsmaskierungsschichtteil 71 herausgeätzt wird.

Danach wird gemäß dem Verfahren der Erfindung die Hauptfläche des Halbleitersubstrats mit der ersten polykristallinen Siliciumschicht 9 gemäß der Fig. 2 bedeckt, auf der die zweite Oxidationsmaskierungsschicht 8 aufgebracht wird, die ebenfalls aus einer unteren, einer Haftung förderlichen Siliciumoxidschicht und aus einer oberen Siliciumnitridschicht bestehen kann.

Im Falle der Mitintegration von Isolierschicht-Feldeffekttransistoren wird bei dem Prozeß der Herstellung des den Emitterbereich 6 bedeckenden ersten Oxidationsmaskierungsschichtteils 71 je ein die Feldoxidschicht 2 überlappender Maskierungsschichtteil 72 bzw. 73 erzeugt, der einen freigelegten Bereich des Halbleitersubstrats in den Öffnungen 32 bzw. 33 enthält und der jeweils am Rande der Öffnung liegt. Im Falle der Herstellung von Isolierschicht-Feldeffekttransistoren kann entsprechend dem bekannten Stand der Technik vor der Herstellung der Gate-Oxidschichten 22 bzw. 23, die der unteren Teilschicht der Oxidationsmaskierungsschicht entsprechen können, die darunter liegende Substratoberfläche entsprechend den gewünschten Feldschwellspannungen durch Ionenimplantation dotiert werden.

Auf die Hauptfläche der Anordnung wird nunmehr mittels einer beispielsweise aus Photolack bestehenden Ätzmaske aus der aus der zweiten Oxidationsmaskierungsschicht 8 und der polykristallinen Siliciumschicht 9 bestehenden Schichtenfolge unter Bildung der oberflächlich von dem Oxidationsmaskierungsschichtteil 81 bedeckten Kollektorelektrode 91 zumindest derjenige Bereich der Halbleiteroberfläche freigelegt, welcher den Basisbereich 11 und einen diesen zumindest teilweise umgebenden Randbereich 12 umfaßt. Dieser Bereich entspricht, wie aus der folgenden Beschreibung klar wird, dem Kontaktierungsbereich der Basiselektrode. Im Falle der Kontaktierung der Emitterzone 4 - vgl. Fig. 7 und 8 - mittels einer Leiterbahn gemäß der Fig. 8 bleibt die Kollektor elektrode 91 vorzugsweise seitlich geöffnet, um niedrige Überlappungskapazitäten zu erzielen.

Beim Verfahren nach der Erfindung ist es auch möglich, daß die Oxidationsmaskierungsschicht den Rand der Feldoxidschicht 2 berührt. Dadurch ergibt sich eine Planartransistorstruktur, bei der die Basiselektrode wie auch die Basiskontaktierungszone die Emitterzone 4 nur teilweise umgibt. In diesem Falle wird nur derjenige Bereich unter Freilegung der Halbleiteroberfläche entfernt, der nicht an die Feldoxidschicht 2 angrenzt.

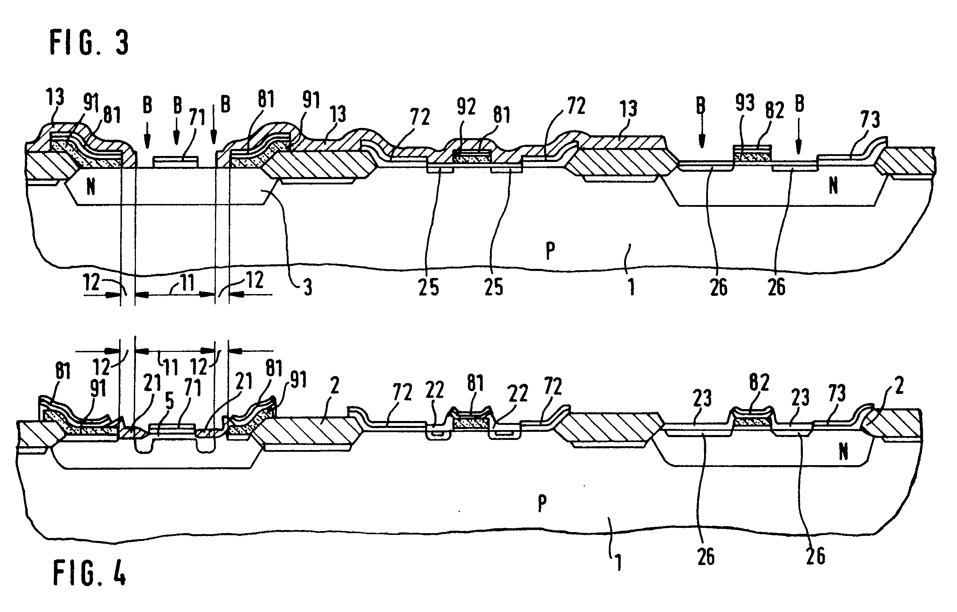

Es wird nun auf die Hauptfläche des Substrats 1 eine Implantationsmaske 13, beispielsweise aus Photolack, aufgebracht, welche eine Öffnung entsprechend dem Basisbereich 11 enthält,wie die Fig. 3 veranschaulicht. Ferner wird gemäß dieser Fig. 3 im Falle der Herstellung von N-Kanal-Feldeffektransistoren mittels der Implantationsmaske 13 die Substratkontaktierungsfläche entsprechende Öffnung 32 innerhalb des Feldoxids 2 abgedeckt. Erfolgt die gleichzeitige Herstellung eines in der Öffnung 33 des Feldoxids 2 angeordneten P-Kanal-Feldeffekttransistors, dessen Substratkontaktierungsbereich mittels des Oxidationsmaskierungsschichtteils 73 bei der Herstellung des den Emitterbereichs 6 bedeckenden ersten Oxidationsmaskierungsschichtteils 71 abgedeckt wurde, dann kann der nun folgende Implantationsprozeß von Dotierungen des Leitfähigkeitstyps der Basiszone 5 des Planartransistors ausgenutzt werden, um die Zonen 26 (Source- und Drainzone) des P-Kanal-Feldeffekttransistors herzustellen, wobei die aus polykristallinem Silicium bestehende Gateelektrode 93, welche von dem Oxidationsmaskierungsschichtteil 82 bedeckt ist und die mit dieser gleichzeitig mit der von dem Oxidationsmaskierungsschicht 81 bedeckten Kollektorelektrode 91 hergestellt wurde, für die selbstausrichtende Herstellung der den Kanalbereich begrenzenden Zonen 26 ausgenutzt wird.

Anschließend erfolgen in beliebiger Reihenfolge zwei Ionen-Implantationsprozesse von Dotierungen des Leitfähigkeitstyps der Basiszone, wobei der eine Implantationsprozeß bei einer relativ hohen Energie erfolgt und der Oxidationsmaskierungsschichtteil 71 durchdrungen wird und der andere Implantationsprozeß bei einer relativ niedrigen Energie erfolgt, so daß der Oxidationsmaskierungsschichtteil 71 maskiert. Bei dieser Gelegenheit werden die Dotierungen der Zonen 26 des P-Kanal-Transistors in die Substratoberfläche implantiert.

Nach einer aus der Fig. 3 nicht ersichtlichen Maskierung der Öffnungen 31 und 33 können mittels einer besonderen Implantationsmaske aus Photolack die Dotierungen der Zonen 25 des N-Kanal-Feldeffekttransistors in die Substratfläche implantiert werden, wobei innerhalb der Öffnung 32 der Oxidationsmaskierungsschichtteil 72, welcher die Zonenkontaktierungsbereich des N-Kanal-Feldeffekttransistors bedeckt, und die vom Oxidationsmaskierungsschichtteil 81 bedeckte Gate-Elektrode 92 maskierend wirken.

Anschließend erfolgt eine thermische Oxidation, deren Wirkung anhand der Fig. 4 ersichtlich ist. Dabei diffundiert das implantierte Dotierungsmaterial unter Aktivierung in das Substrat 1. Ferner wird das freiliegende oder auch lediglich von den Teilen der Gate-Oxidschichtteile 22 und 23 bedeckte Silicium oxidiert, wobei in der Öffnung 31 des bipolaren Planartransistors ein den ersten Oxidationsmaskierungsschichtteil 71 umgebender Oxidrahmen 21 gebildet wird und der Rand der Kollektorelektrode 91 oxidiert wird. Dabei entstehen aufgrund der Volumenausdehnung bei der Oxidation Oxidschichtteile in Form je eines Vogelschnabels (bird's beak). In dem Falle der Berührung des Oxidationsmaskierungsschichteils 71 mit dem Feldoxid 2 umgibt der Oxidrahmen 21 lediglich teilweise den Emitterbereich, nämlich lediglich dort, wo der Oxidationsmaskierungsschichtteil 71 das Feldoxid 2 nicht berührt.

Bei dieser Oxidation werden bei der Weiterbildung des Verfahrens nach der Erfindung die freiliegenden Ränder der Gate-Elektroden 92 und 93 in gleicher Weise thermisch oxidiert, wobei sich die auf den Zonen 25 und 26 befindlichen Oxidschichten verdicken.

Anschließend werden sämtliche Oxidationsmaskierungsschichtteile, also zumindest bei Verzicht auf Feldeffekttransistoren die Teile 71 und 81 des bipolaren Planartransistors entfernt, wie die Fig. 4 veranschaulicht.

Dann wird, im Falle einer Diffusion der Emitterzone aus der dotierten Emitterelektrode vor oder im Falle der Dotierung der Emitterzone durch einen besonderern Implantationsprozeß nach dem Einbringen der Dotierungen, die Emitterelektrode 14 aus dotiertem polykristallinem Silicium aufgebracht, welche im letzteren Falle natürlich Dotierungen vom Leitungstyp der Emitterzone 4 enthalten muß.

Um einem minimalen Basiswiderstand zu erhalten, müssen Maßnahmen getroffen werden, um die Basiselektrode möglichst nahe der Emitterelektrode an der Substratoberfläche, jedoch im geringsten Abstand, anzubringen. Bei dem Verfahren nach der Erfindung wird von dem Gedanken Gebrauch gemacht, diesen Abstand durch die Dicke des Oxidrahmens 21 auf einen so geringen Abstand zu bringen, daß gerade ein Kurzschluß zwischen der Emitterelektrode und der Basiselektrode ausgeschlossen wird. Die Dicke des Oxidrahmens 21 jedenfalls ist sehr genau durch ein gesteuerte thermische Oxidation zu beherrschen. Ist nun aber die optimal kleine Dicke dieses den Abstand der Elektroden bestimmenden Oxidrahmens optimal klein eingestellt, so bedarf es keiner extrem genauen Justierung der den inneren Rand des Oxidrahmens 21 überlappenden Emitterelektrode 14 mehr. Der photolithographische Ätzprozeß zum Herausätzen der Emitterelektrode 14 aus einer die Anordnung bedeckenden polykristallinen Siliciumschicht erfordert somit keine sehr große Genauigkeit, also keinen besonders kleinen Sicherheitsabstand. Berührt der Oxidationsmaskierungsschichtteil 71 den Rand des Feldoxides 2, dann hat die Emitterelektrode zum einen Teil den inneren Rand des Oxidrahmens 21 zu überlappen und zum anderrn Teil den Rand des Emitterbereichs, der an den Rand des Feldoxids 2 grenzt. Jedenfalls ist darauf zu achten, daß der gesamte Rand der Emitterelektrode 14 einen ausreichend großen Abstand zu der senkrecht darunter liegenden Substratoberfläche erhält.

Bei der bevorzugten Weiterbildung des Verfahrens nach der Erfindung werden zur Herstellung mindestens eines Isolierschicht-Feldeffekttransistors in den Öffnungen 32 bzw. 33 an der durch Entfernen der Oxidationsmaskierungsschichtteile 72 bzw. 73 freigelegten Substratoberfläche innerhalb mindestens einer der weiteren Öffnungen 32 bzw. 33 die Elektroden 24 bzw. 26 an den darunter liegenden Teilen der Substratoberfläche angebracht. Da diese Elektroden in gleicher Weise und gleichzeitig mit der Emitterelektrode 14 aus einer einheitlichen dotierten polykristallinen Siliciumschicht hergestellt werden, wirken diese als Diffusionsquellen für n-dotierende Verunreinigugen, bilden also bei einem Prozeß mit ausreichenden Temperaturen Kontaktierungszonen 95 für die Zonen 25 des N-Kanal-Feldeffekttransistors und eine Kontaktierungszone 96 für die Substratzone 3' des P-Kanal-Feldeffekttransistors, wie die Fig. 6 veranschaulicht.

Vor dieser thermischen Behandlung wird jedoch unter Verwendung einer Ätzmaskierung, vorzugsweise aus Photolack, eine anisotrope Ätzung durchgeführt, wobei der überlappende Teil der Emitterelektrode 14 als Ätzmaske verwendet wird und der Oxidrahmen 21 aus der Gasphase bis auf die Halbleiteroberfläche unter Bildung eines freiliegenden Substratbereichs 18 entfernt wird. Damit entsteht unter dem Rand der Emitterelektrode 14 ein sie zumindest teilweise einschließender Oxidstreifen 15, wie die Fig. 6 zeigt. Da der Rand der Kollektorelektrode 91 bei der Oxidation zum Herstellen des Oxidrahmens 21 ebenfalls oxidiert worden ist, ist der Rand der Kollektorelektrode 91 ebenfalls bis auf den Teil 9' eingefaßt, an dem die Kollektorelektrode in das Leiterbahnenmuster einläuft. Dies veranschaulichen die Fig. 7 und 8. Die Fig. 7 ist eine Ausschnittsvergrößerung des bipolaren Planartransistors der Fig. 6 und die Fig. 8 eine Aufsicht auf die Fig. 7, die einen Schnitt entlang der Linie A---A der Fig. 8 zeigt. In der Fig. 8 bedeutet die teilweise gestrichelte Linie 27 der Rand den Öffnung 31.

Um auszuschließen, daß der PN-Übergang zwischen der Basiskontaktierungszone 5' und der Kollektorzone 3 oberflächlich durch die Basiselektrode kurzgeschlossen wird, werden anschließend in den freiliegenden Substratbereich 18 Ionen vom Leitungstyp der Basiszone 5 implantiert. Es entsteht also ein Kontaktierungszonenteil 5" bei einer späteren Diffusion, wie die Fig. 7 deutlich erkennen läßt. Bei dieser Diffusion diffundieren aus der Kollektorelektrode 91 Dotierungen vom Leitungstyp der Kollektorzone unter Ausbildung der Kollektorkontaktierungszone 94.

Bei dem Implantationsprozeß von Verunreinigungen des Leistungstyps der Basiszone, beispielsweise Bor im Falle eines integrierten NPN-Planartransistors, sollte zumindest der Bereich des N-Kanal-Feldeffekttransistors mittels einer Photolackmaske geschützt werden, wenn die Ausbildung eines störenden PN-Übergangs an der Oberfläche der n-dotierten Zonen 25 zu befürchten ist.

Es erfolgt dann das Aufbringen einer Metallschicht aus einem ein Silicid bildenden Metall auf die Hauptfläche der Anordnung in einer Dicke geringer als die Dicke des Oxidstreifens 15, um einen Kurzschluß zwischen der Emitterelektrode 14 und der Basiselektrode sicher auszuschließen. Dann wird die Anordnung soweit erhitzt, daß sich auf der Emitterelektrode 14, der Kollektorelektrode 91 und dem freiliegenden Substratbereich 18 eine Silicidschicht 17 bildet.

Werden bei dem Prozeß b der Herstellung der Kollektorelektrode und/oder dem Prozeß e der Herstellung der Emitterelektrode aus dotiertem polykristallinem Silicium Leitbahnenmuster aus den polykristallinen Siliciumschichten herausgeätzt, welche die Kollektorelektrode 91 bzw. die Emitterelektrode 14 enthalten, so werden diese Leiterbahnenmuster natürlich ebenfalls von dieser Metallschicht bedeckt. Gleiches gilt, wenn entsprechend der Weiterbildung des Verfahrens nach der Erfindung Leiterbahnenmuster hergestellt werden, welche die Gate-Elektroden 92 und 93 oder auch noch die Kollektorkontaktierungselektrode 27 des P-Kanal-Feldeffekttransistors enthalten.

Es erfolgt, anschließend eine Erhitzung der Anordnung soweit, daß sich zumindest auf der Emitterelektrode 14, der Kollektorelektrode 91 und der freiliegenden Substratbereich 18 eine Silicidschicht 17 bildet. Im Falle der Verwendung von Platin, welches sich bekanntlich in Königswasser löst, entsteht bei der Erhitzung also eine Platinsilicidschicht, welche kaum von Königswasser angegriffen wird. Wird entsprechend dem Verfahren nach der Erfindung also die Anordnung in Königswasser getaucht, so wird lediglich das nicht durch Bildung eines Silicids verbrauchte Platin entfernt und es verbleiben auf den Elektroden und im Falle der Weiterbildung des Verfahrens nach der Erfindung der Herstellung von Leiterbahnenmustern auf den Leiterbahnen und den Elektroden Platinsilicidschichten, welche wesentlich geringere Zuleitungswiderstände aufweisen, als es mit lediglich dotierten polykristallinen Schichten möglich ist.

Nach der Fig. 8, liegen die aktiven Zonenteile des bipolaren Planartransistors innerhalb des Randes 28 der Öffnung 31(Fig. 1) der Feldoxidschicht 2. Diese wird zumindest im Bereich des Schnittes A--A von Kontaktelektrodenteilen 91 überlappt. Die Kollektorelektrode 91 umgibt U-förmig den Basisbereich 11 und einen daran angrenzenden Kollektorzonenbereich 12. Die Kollektorelektrode geht über den Kollektorelektrodenteil 9' in des Leitbahnenmuster über und ist bis auf diesen Anschlußteil 9' von einem Oxidstreifen 16 eingeschlossen. Die Kollektorelektrode 91 umgibt die Emitterelektrode 14 lediglich teilweise, um Platz für das Leitbahnenmuster zu lassen, in das die Emitterelektrode 14 übergeht. Im Bereich der Emitterzone 4 ist sie von dem Oxidstreifen 15 eingeschlossen, der an der Seite, wo die Emitterelektrode in das Leitbahnenmuster übergeht, bis an das Feldoxid 2 reicht. Dort ist nämlich die anisotrope Ätzung bis auf das Substrat maskiert. Die gestrichelt gezeichnete Basiselektrode 17 aus einem Silicid, beispielsweise dem genannten Platinsilicid, würde den PN-Übergang zwischen der Basiszone 5 bzw. der Basiskontaktierungszone 5' kurzschließen, wenn unterhalb der Basiselektrode 17 nicht ein Kontaktierungszonenteil 5'' angeordnet wäre, wie die Fig. 7 zeigt. Die Kontaktierung der Basiselektrode erfolgt durch die Kontaktierungsöffnung 29 innerhalb einer Fremdoxidschicht, welche auf die gesamte Anordnung aufgebracht wird mittels eines auf die Fremdoxidschicht aufgebrachten metallischen Leitbahnenmusters.

Eine Weiterbildung des Verfahrens nach der Erfindung zur Herstellung von hochintegrierten Schaltungen mit silicierten Leiterbahnen und CMOS-Schaltkreisen hat somit den Vorteil, daß sowohl die Vorteile von sehr schnellen Bipolartransistoren als auch der Vorteil eines geringen Leistungsverbrauchs von CMOS-Schaltkreisen, beispielsweise in logischen Peripherie-Schaltkreisen, ausgenutzt werden können.

## Patentansprüche

1. Verfahren zum Herstellen einer monolithisch integrierten Schaltung mit mindestens einem bipolaren Planartransistor, welcher innerhalb einer Öffnung (31) einer die Hauptfläche eines Halbleitersubstrats (1) bedeckenden Feldoxidschicht (2) gebildet ist wobei zur Herstellung von einer innerhalb der Kollektorzone (3) des Planartransistors ausgebildeten Emitterzone (4) und Basiszone (5, 5')

- ein Emitterbereich (6) mit einem Oxidationsmaskierungsschichtteil (71) einer ersten Oxidationsmaskierungsschicht solcher Dicke bedeckt wird, daß dieser während der Herstellung der Basiszone (5,5') bei einem Ionen-Implantationsprozeß hoher Energie von Dotierungen des Leitungstyps der Basiszone (5,5')-durchdrungen wird und bei einem anderen Ionen-Implantationsprozeß niedriger Energie von Dotierungen des Leitungstyps der Basiszone (5,5') als Maske wirkt, und

- nach den genannten Ionen Implantationsprozessen, welche unter Verwendung einer einen Basisbereich (11) definierenden Implantationsmaske (13) erfolgen, die nach Entfernung dieser Implantationsmaske (13) freiliegende Halbleitersubstratoberfläche unter Bildung eines den Emitterbereich (6) zumindest teilweise umgebenden Oxidrahmens (21) thermisch oxidiert und danach der erste Oxidationsmaskierungsschichtteil (71) entfernt wird.

gekennzeichnet durch folgende Verfahrensschritte:

a) nach der Herstellung des den Emitterbereich (6) bedeckenden ersten Oxidationsmaskierungsschichtteils (71) wird die Hauptfläche des Halbleitersubstrats mit einer ersten polykristallinen Siliciumschicht (9) bedeckt, auf der eine zweite Oxidationsmaskierungsschicht (8) aufgebracht wird;

b) danach wird aus der aus der zweiten Oxidationsmaskierungsschicht (8) und der polykristallinen Siliciumschicht (9) bestehenden Schichtenfolge unter Bildung der Kollektorelektrode (91) welche oberflächlich von einem zweiten Oxidationsmaskierungsschichtteil (81) bedeckt ist, zumindest derjenige Bereich unter Freilegung der Halbleitersubstratoberfläche entfernt, welcher den Basisbereich (11) und einen diesen zumindest teilweise umgebenden Randbereich (12) bedeckt hatte;

c) dann erfolgen die genannten Ionen-Implantationsprozesse zur Herstellung der Basiszone (5,5') unter Verwendung der den Basisbereich (11) definierenden Implantationsmaske (13), die anschließend entfernt wird;

d) danach werden die freiliegende Halbleitersubstratorberfläche unter Bildung des den ersten Oxidationsmaskierungsschichtteil (71) umgebenden Oxidrahmens (21) und der Rand der Kollektorelektrode (91) thermisch oxidiert und danach der erste Oxidationsmaskierungsschichtteil (71) und der auf der Kollektorelektrode (91) befindliche zweite Oxidationsmaskierungsschichtteil (81) entfernt;

e) dann wird vor oder nach dem Einbringen der Dotierungen der Emitterzone (4) eine Emitterelektrode (14) aus dotiertem polykristallinem Silicium aufgebracht, welche den inneren Rand des Oxidrahmens (21) überlappt;

f) danach erfolgt eine aniostrope Ätzung, wobei der überlappende Teil der Emitterelektrode (14) als Ätzmaske verwendet wird und der Oxidrahmen (21) aus der Gasphase bis auf die Halbleiteroberfläche unter Bildung eines freiliegenden Substratbereichs (18) entfernt wird, so daß unter dem Rand der Emitterelektrode (14) ein sie zumindest teilweise einschließender Oxidstreifen (15) entsteht und der Rand der Kollektorelektrode (91) von einem Oxidband (16) zumindest teilweise eingefaßt wird;

g) anschließend werden in den freiliegenden Substratbereich (18) Ionen Leitungstyp der Basiszone (5) implantiert;

h) dann erfolgt das Aufbringen einer Metallschicht aus einem silicid-bildenden Metall auf die Hauptfläche in einer Dicke geringer als die Dicke des Oxidstreifens (15) und eine Erhitzung der Anordnung soweit, daß sich auf der Emitterelektrode (14), der Kollektorelektrode (91) und dem freiliegenden Substratbereich (18) eine Silizidschicht (17) bildet; und

i) anschließend wird die Anordnung in ein Ätzmittel gebracht, welches selektiv das Metall, jedoch nicht das Silizid entfernt.

2. Verfahren nach Anspruch 1, dadurch gekennzeichnet, daß

a') bei dem Prozeß a vor der Erzeugung der polykristallinen Siliziumschicht (9) in mindestens einer weiteren Öffnung (32; 33) der Feldoxidschicht (2) die Gate-Oxidschicht (22; 23) eines Isolierschicht-Feldeffekttransistors und daneben bei der Herstellung des den Emitterbereich (6) bedeckenden Oxidationsmaskierungsschichtteils (71) aus der ersten Oxidationsmaskierungsschicht ein die Feldoxidschicht (2) überlappender Maskierungsschichtteil (72; 73) erzeugt wird, der einen freigelegten Bereich des Halbleitersubstrats enthält und der am Rande der mindestens einen weiteren Öffnung (32; 33) liegt, das

b') bei dem Prozeß b aus der aus der zweiten Oxidationsmaskierungsschicht (8) und der polykristallinen Siliciumschicht (9) bestehenden Schichtenfolge mindestens eine auf der Gate-Oxdschicht (22; 23) angeordnete Gate-Elektrode (92; 93) erzeugt wird, die von einem Oxidationsmaskierungsschichtteil (81; 82) bedeckt ist, daß

c') bei dem Prozeß c eine Implantationsmaske (13) verwendet wird, welche die mindestens eine in der Feldoxidschicht (2) vorgesehene weitere Öffnung (32) für den Isolierschicht-Feldeffekttransistor bedeckt, der Zonen (25) vom Leitungstyp der Basiszone (5) des bipolaren Planartransistors enthält, daß

d') bei dem Prozeß d der freiliegende Rand der Gate-Elektrode (92;93) bzw. die freiliegenden Ränder der Gate-Elektroden (92, 93) thermisch oxidiert werden und sämtliche Oxidationsmaskierungsschichtteile (71; 72; 73, 81; 82) danach entfernt werden, und daß

e') bei dem Prozeß e gleichzeitig mit der Emitterelektrode (14) an der durch Entfernung der Oxidationsmaskierungsschichtteile (72, 73) freigelegten Halbleitersubstratoberfläche innerhalb mindestens einer der weiteren Öffnungen (32; 33) Elektroden (24, 25, 26) an den darunter liegenden Teilen der Halbleitersubstratoberfläche angebracht werden.

3. Verfahren nach Anspruch 1 oder 2, dadurch gekennzeichnet, daß aus der aus der zweiten Oxidationsmaskierungsschicht (8) und der polykristallinen Siliciumschicht (9) bestehenden Schichtenfolge beim Prozeß b bzw. b' solche Bereiche entfernt werden, daß ein die Kollektorelektrode (91) enthaltendes Leiterbahnenmuster entsteht.

4. Verfahren nach einem der Ansprüche 2 und 3, dadurch gekennzeichnet, daß beim Prozeß b bzw. b' solche Bereiche aus der aus der zweiten Oxidationsmaskierungsschicht (8) und der polykristallinen Siliciumschicht (9) bestehenden Schichtenfolge entfernt werden, daß ein Leiterbahnenmuster entsteht, welches mindestens eine Gate-Elektrode (92,93) des Isolierschicht-Feldeffekttransistors enthält.

**Claims**

1. Method of manufacturing a monolithic integrated circuit containing at least one bipolar planar transistor which is formed within an opening (31) of a filed-oxide layer (2) covering the major surface of a semi conductor substrate (1), wherein to form an emitter region (4) and a base region (5, 5') within the collector region (3) of the planar transistor,

- an emitter area (6) is covered with an oxidation masking layer portion (71) of a first oxidation masking layer of such a thickness that during the formation of the base region (5, 5'), said emitter area (6) is penetrated in a high-energy ion implantation process for introducing impurities of the conductivity type of the base region (5, 5') and acts as a mask in another, low-energy ion implantation process for introducing impurities of the conductivity type of the base region (5, 5'), and
- after said ion implantation processes, which are carried out using an implantation mask (13) defining a base area (11), the semi conductor substrate surface exposed after removal of said implantation mask (13) is thermally oxidized to form an oxide frame (21) surrounding at least part of the emitter area (6), and thereafter the first oxidation masking layer portion (71) is removed,

characterized by the following steps:

a) After the production of the first oxidation masking layer portion (71) covering the emitter area (6), the major surface of the semiconductor substrate is covered with a first polycrystalline silicon layer (9) on which a second oxidation masking layer (8) is deposited;

b) from the succession of layers consisting of the second oxidation masking layer (8) and the polycrystalline silicon layer (9), at least the portion covering the base area (11) and an edge area (12) surrounding at least part of the base area (11) is removed to form the collector electrode (91), which is covered at the surface by a second oxidation masking layer portion (81), and to expose the semiconductor substrate surface;

c) then, said ion implantation processes are carried out to form the base region (5, 5') using the implantation mask (13) defining the base area (11), which implantation mask is subsequently removed;

d) after that, the exposed semiconductor substrate surface and the edge of the collector electrode (91) are thermally oxidized, the thermal oxidation of the exposed semiconductor substrate surface forming the oxide frame (91) surrounding the first oxidation masking layer portion (71), and then the first oxidation masking layer portion (71) and the second oxidation masking layer portion (81) on the collector electrode (91) are removed;

e) then, prior to or after the introduction of the impurities of the emitter region (4), an emitter electrode (14) of doped polycrystalline silicon is deposited which overlaps the inner edge of the oxide frame, (21);

f) this is followed by an anisotropic etching step in which the overlapping portion of the emitter electrode (14) is used as an etch mask and in which the oxide frame (21) is removed from the vapor phase down to the semiconductor surface to form an exposed substrate area (18), so that an oxide strip (15) surrounding at least part of the emitter electrode (14) is obtained be-low the edge of the emitter electrode (14) and the edge of the collector electrode (91) is surrounded at least in part by an oxide band (16);

g) next, ions of the conductivity type of the base region (5) are implanted into the exposed substrate area (18);

h) then, a layer of a silicide-forming metal is deposited on the major surface in a thickness less than the thickness of the oxide strip (15), and the structure is heated until a silicide layer (17) forms on the emitter electrode (14), the collector electrode (91), and the exposed substrate area (18), and

i) finally, the structure is put into an etchant which selectively removes the metal but not the silicide.

2. A method as claimed in claim 1, characterized in that

a') in the process a, prior to the production of the polycrystalline silicon layer (9), in at least one additional opening (32; 33) of the field-oxide layer (2), the gate oxide layer (22; 23) of an insulated-gate field-effect transistor and, beside it, during the formation of the oxidation masking layer portion (71) covering the emitter area (6) from the first oxidation masking layer, a masking layer portion (72; 73) overlapping the field oxide layer (2) is produced which includes an exposed area of the semiconductor substrate and lies at the edge of the at least one additional opening (32; 33), that

b') in the process b, at least one gate electrode (92; 93) disposed on the gate oxide layer (22; 23) is formed from the succession of layers consisting of the second oxidation masking layer (8) and the polycrystalline silicon layer (9), said at least one gate electrode (92; 93) being covered by an oxidation masking layer portion (81; 82), that

c') in the process c, an implantation mask (13) is used which covers the at least one additional opening (32) provided in the field oxide layer (2) for the insulated-gate field-effect transistor, which contains regions (25) of the conductivity type of the base region (5) of the bipolar planar transistor, that

d') in the process d, the uncovered edge of the gate electrode (92; 93) or the uncovered edges of the gate electrodes (92, 93) are thermally oxidized and all oxidation masking layer portions (71; 72; 73; 81; 82) are subsequently removed, and that

e') in the process e, simultaneously with the emitter electrode (14) at the semiconductor substrate surface exposed by removal of the oxidation masking layer portions (72, 73), electrodes (24, 25, 26) are formed within at least one of the additional openings (32; 33) at the underlying portions of the semiconductor substrate surface.

3. A method as claimed in claim 1 or 2, characterized in that from the succession of layers consisting of the second oxidation masking layer (8) and the polycrystal-line silicon layer (9), those portions are removed in the process b or b' that a conductor pattern containing the collector electrode (91) is obtained.

4. A method as claimed in claims 2 and 3, characterized in that in the process b or b', those portions are removed from the succession of layers consisting of the second oxidation masking layer (8) and the polycrystalline silicon layer (9) that a conductor pattern containing at least one gate electrode (92; 93) of the insulated-gate field-effect transistor is obtained.

**Revendications**

1. Procédé pour fabriquer un circuit intégré monolithique comportant au moins un transistor planar bipolaire qui est forme' à l'interieur d'une ouverture (31) ménagée dans une couche d'oxyde de champ (2) recouvrant la surface principale d'un substrat semiconducteur (1), et selon lequel pour fabriquer une zone d'émetteur (4) et une zone de base (5,5'), formées a l'intérieur de la zone de collecteur (3) du transistor planar,

- on recouvre une zone d'émetteur (6) par une partie (71) d'une première couche de masquage contre l'oxydation, possédant une épaisseur telle que cette couche est traversée, pendant la fabrication de la zone de base (5,5') lors d'un processus d'implantation ionique avec une énergie élevée de substances dopantes possédant le type de conductivité de la zone de base (5,5') et agit en tant que masque lors d'un autre processus d'implantation ionique a faible énergie de substances dopantes possédant le type de conductivité de la zone de base (5,5'),

- après lesdits processus d'implantation ionique, qui s'effectuent moyennant l'utilisation d'un masque d'implantation (13), qui définit une zone de base (11), on oxyde thermiquement la surface du substrat semiconducteur mise à nu après élimination de ce masque d'implantation (13), moyennant la formation d'un cadre d'oxyde (21) entourant au moins partiellement la zone d'émetteur (6), et on élimine ensuite la première partie (71) de la couche de masquage contre l'oxydation,

caractérisé par les étapes opératoires suivantes :

a) après la fabrication de la première partie (71) de la couche de masquage contre l'oxydation, qui recouvre la zone d'émetteur (6), on recouvre la surface principale du substrat semiconducteur par une première couche de silicium polycristallin (9), sur laquelle on dépose une seconde couche de masquage contre l'oxydation (8);

b) puis, dans la suite de couches constituée par la seconde couche de masquage contre l'oxydation (8) et par la couche de silicium polycristallin (9), moyennant la formation de l'électrode de collecteur (91), dont la surface est recouverte par une seconde partie (81) de la couche de masquage contre l'oxydation, et en dégageant la surface du substrat semiconducteur, on élimine la zone qui avait recouvert la zone de base (11) et une zone marginale (12) entourant au moins partiellement cette zone;

c) ensuite, on met en oeuvre les processus indiqués d'implantation ionique servant à fabriquer la zone de base (5,5') moyennant l'utilisation du masque d'implantation (13), qui désigne la zone de base (11) et qui est ensuite éliminé;

d) ensuite, on réalise une oxydation thermique de la surface à nu du substrat semiconducteur, moyennant la formation du cadre d'oxyde (21) entourant la première partie (71) de la couche de masquage contre l'oxydation, et le bord de l'électrode de collecteur (91), puis on élimine la première partie (71) de la couche de masquage contre l'oxydation et la seconde partie (81) de la couche de masquage contre l'oxydation, située sur l'électrode de collecteur (91);

e) ensuite on dépose, avant ou après l'insertion des substances dopantes de la zone d'émetteur (4), une électrode d'émetteur (14) réalisée en silicium polycristallin dopé, qui chevauche le bord intérieur du cadre d'oxyde (21);

f) ensuite, on met en oeuvre une corrosion anisotrope, lors de laquelle on utilise la partie en chevauchement de l'électrode d'émetteur (14) en tant que masque contre la corrosion et on élimine le cadre d'oxyde (21) à partir de la phase gazeuse jusqu'à la surface semiconductrice en formant une zone à nu (18) du substrat, de sorte qu'au-dessous du bord de l'électrode d'émetteur (14) apparaît une bande d'oxyde (15) qui enserre au moins partiellement cette électrode, et on enserre au moins partiellement le bord de l'électrode de collecteur (91) par une bande d'oxyde (16);

g) ensuite, on implante des ions possédant le type de conductivité de la zone de base (5), dans la région à nu (18) du substrat;

h) ensuite, on dépose sur la surface principale une couche métallique formée d'un métal formant un siliciure et possédant une épaisseur inférieure à l'épaisseur de la bande d'oxyde (15) et on chauffe le dispositif pour qu'il se forme une couche de siliciure (17) sur l'électrode d'émetteur (14), sur l'électrode de collecteur (91) et sur la zone à nu (18) du substrat; et

i) on introduit ensuite le dispositif dans un agent corrosif, qui élimine de façon sélective le métal, mais pas le siliciure.

2. Procédé selon la revendication 1, caractérisé en ce que

a') lors de l'opération a, avant la production de la couche de silicium polycristallin (9), on forme, dans au moins une autre ouverture (32;33) de la couche d'oxyde de champ (2), la couche d'oxyde de grille (22; 23) d'un transistor à effet de champ à couche isolante et en outre, lors de la fabrication de la partie (71) de la couche de masquage contre l'oxydation, qui recouvre la zone d'émetteur (6), on forme une partie (72; 73) de la couche de masquage qui est en chevauchement sur la couche d'oxyde de champ (2), contient une zone à nu du substrat semiconducteur et est située sur le bord d'au moins une autre ouverture (32;33),

b') lors de l'opération b, on forme, à partir de la succession de couches constituée par la seconde couche de masquage contre l'oxydation (8) et par la couche de silicium polycristallin (9), au moins une électrode de grille (92; 93) située sur la couche d'oxyde de grille (22;23) et recouverte par une partie (81;82) de la couche de masquage contre l'oxydation,

c') lors de l'opération c, on utilise un masque d'implantation (13), qui recouvre au moins une autre ouverture (32) prévue dans la couche d'oxyde de champ (2) pour le transistor à effet de champ à couche isolante, qui contient des zones (25) possédant le type de conductivité de la zone de base (5) du transistor planar bipolaire,

d') lors de l'opération d, on réalise l'oxydation thermique du ou des bords dégagés des électrodes de grille (92; 93) et on élimine toutes les parties (71;72;73;81;82) de la couche de masquage contre l'oxydation, et

e') lors de l'opération e, on dépose, en même temps que l'électrode d'émetteur (14), sur la surface du substrat semiconducteur mise à nu par l'élimination des parties (72;73) de la couche de masquage contre l'oxydation, à l'intérieur d'au moins l'une des autres ouvertures (32;33), des électrodes (24,25,26) sur les parties sous-jacentes de la surface du substrat semiconducteur.

3. Procédé selon la revendication 1 ou 2, caractérisé en ce que lors de l'opération b ou b', on élimine, à partir de la succession de couches constituée par la seconde couche de masquage contre l'oxydation (8) et par la couche de silicium polycristallin (9), des zones telles qu'il apparaît un modèle de voies conductrices contenant l'électrode de collecteur (91).

4. Procédé selon l'une des revendications 2 et 3, caractérisé en ce que lors de l'opération b ou b', on élimine, de la seconde couche de masquage contre l'oxydation (8) et de la couche de silicium polycristallin (9), des zones telles que l'on obtient un modèle de voies conductrices, qui contient au moins une électrode de grille (92,93) du transistor à effet de champ à couche isolante.

FIG. 1

FIG. 2

FIG. 3

FIG. 4

EP 0 239 652 B1

FIG. 6

FIG. 5

## FIG. 7

## FIG. 8